# EUROPÄISCHE PATENTANMELDUNG

(11) **EP 4 420 859 A1**
(43) Veröffentlichungstag der Anmeldung: **28.08.2024**
(21) Anmeldenummer: 24152852.0
(22) Anmeldetag: 19.01.2024
(51) Int. Cl.: B29C 64/106, B29C 64/209, B29C 64/268, B33Y 10/00, B33Y 30/00, B33Y 40/00, G02B 21/33, G03F 7/16, G03F 7/20, G03F 7/00

(54) **LASERLITHOGRAFIE-VORRICHTUNG UND VERFAHREN ZUM ERZEUGEN EINER DREIDIMENSIONALEN STRUKTUR**

(30) Priorität: 27.02.2023 DE 102023104751
(71) Anmelder: Nanoscribe Holding GmbH, 76344 Eggenstein-Leopoldshafen (DE)
(72) Erfinder: Hippler, Marc, 76344 Eggenstein-Leopoldshafen (DE); Thiel, Michael, 76135 Karlsruhe (DE)
(74) Vertreter: DREISS Patentanwälte PartG mbB

(57) **Zusammenfassung**

Laserlithografie-Vorrichtung (10) zum Erzeugen einer dreidimensionalen Struktur in einem Lithografiematerial (12) mit einer Laserquelle (18) zur Aussendung eines Laser-Schreibstrahls (20) und einem Objektiv (22) zur Fokussierung des Laser-Schreibstrahls (20) in einem Fokusbereich (24). Das Objektiv (22) weist ein optisches Abschlusselement (44) auf. Weiter umfasst die Laserlithografie-Vorrichtung eine Scan-Einrichtung (28, 30, 32) zur Verlagerung des Fokusbereichs (24) des Laser-Schreibstrahls (20) relativ zu dem Lithografiematerial (12) und eine Schutz-Einrichtung (46) zum Verhindern eines Kontakts zwischen dem optischen Abschlusselement (44) und dem Lithografiematerial (12). Die Schutz-Einrichtung (46) ist an dem optischen Abschlusselement (44) angeordnet.

## Beschreibung

Die Erfindung betrifft eine Laserlithografie-Vorrichtung und ein Verfahren zum Erzeugen einer dreidimensionalen Struktur mittels einer Laserlithografie-Vorrichtung.

Die im vorliegenden Zusammenhang mit Laserlithografie bezeichnete Technik wird beispielsweise auch als Stereo-Lithografie oder direktes Laserschreiben (englisch: direct laser writing) bezeichnet. Bei dieser Technik werden Strukturen mittels eines Laser-Schreibstrahls in eine in der Regel zunächst flüssige, fotosensitive Substanz geschrieben, die im vorliegenden Zusammenhang als Lithografiematerial bezeichnet wird. Hierbei wird durch den Laser-Schreibstrahl in dem Lithografiematerial lokal ein Verfestigungseffekt ausgelöst. Die Verfestigung erfolgt dabei beispielsweise aufgrund einer durch Photonen-Absorption induzierte, lokale Polymerisation des Lithografiematerials. Im Bereich der optischen Lithografie wird ein derartiges Lithografiematerial auch als Fotolack bezeichnet. Im Bereich der Stereolithographie spricht man auch von Resin oder Harz.

Die Technik der Laserlithografie bzw. des direkten Laserschreibens wird in vorteilhafterweise bei der Erzeugung von Mikro- oder Nanostrukturen eingesetzt, wenn eine hohe Präzision erwünscht ist und gleichzeitig Gestaltungsfreiheit und Flexibilität in der Formgebung erhalten bleiben soll. Anders als z.B. bei Verfahren der Maskenlithografie können nämlich verschiedene Strukturen geschrieben werden, ohne dass die Struktur durch eine Maske oder Ähnliches vorgegeben ist.

Hierbei sind verschiedene Techniken bekannt, die in unterschiedlichem Maße zu einem direkten Kontakt zwischen der Fokussieroptik bzw. deren optischem Abschlusselement und dem Lithografiematerial führen können. Grundsätzlich ist es zunächst bekannt, dass die gewünschte Gesamtstruktur dadurch erzeugt wird, dass sequentiell eine Reihe von Teilstrukturen (beispielsweise lagenweise oder scheibenweise) geschrieben werden, die sich dann insgesamt zu der gewünschten Struktur ergänzen.

Bei einer Art bekannter Techniken trifft der Schreibstrahl auf die Oberfläche eines Volumens an Lithografiematerial und führt an der Oberfläche zu einer lokalen Verfestigung. In der Regel liegen diesen Verfahren lineare Prozesse wie Ein-Photonen-Absorption und daraus resultierende, lokale Veränderung des Lithografiematerials zugrunde. Um dreidimensional ausgedehnte Strukturen zu schreiben, wird bei derartigen Verfahren nach dem Beschreiben einer Lage in einem Applikationsschritt eine zusätzliche Lage Lithografiematerial aufgetragen. Dies kann beispielsweise dadurch erreicht werden, dass ein Substrat mit der hierauf zu schreibenden Struktur schrittweise in einem Bad aus Lithografiematerial abgesenkt wird und die Strukturierung mittels des Schreibstrahls jeweils an der Oberfläche erfolgt. Bei derartigen Techniken kann es vorkommen, dass das Abschlusselement der Fokussieroptik mit Lithografiematerial in Kontakt gerät.

Ein anderer Ansatz nutzt das physikalische Prinzip der Zwei-Photonen-Polymerisation oder allgemein Multi-Photonen-Polymerisation aus, um eine Verfestigung von Lithografiematerial auch innerhalb eines Volumens an Lithografiematerial, also auch unterhalb der Oberfläche zu erzielen. Dies wird dadurch ermöglicht, dass Schreibstrahl und Lithografiematerial derart aufeinander abgestimmt sind, dass ein Verfestigungseffekt unter Mitwirkung nichtlinearer Effekte erfolgt. Beispielsweise wird der Schreibstrahl in einem Spektralbereich gewählt, der normalerweise keinen Verfestigungseffekt in dem Lithografiematerial auslösen kann. Beispielsweise können Lithografiematerial und Schreibstrahl derart aufeinander abgestimmt sein, dass eine induzierte Verfestigung nur durch Strahlung erfolgen könnte, die eine Wellenlänge aufweist, welche einem Bruchteil (insbesondere einen ganzzahligen Bruchteil) der Wellenlänge des tatsächlich verwendeten Schreibstrahls entspricht. Dadurch ist ein Verfestigungsprozess nur unter gleichzeitiger Absorption von zwei oder mehr Photonen des Schreibstrahls möglich (Zwei-Photonen-Polymerisation oder Multi-Photonen-Polymerisation). Im vorliegenden Zusammenhang wird mit dem Begriff Multi-Photonen-Polymerisation die induzierte Polymerisation durch gleichzeitige Absorption von zwei oder mehr als zwei Photonen bezeichnet. Insofern schließt für die vorliegende Beschreibung der Begriff "Multi-Photonen-Absorption" auch den Prozess der "Zwei-Photonen-Absorption" und "Zwei-Stufen-Absorption" mit ein. Die für eine Multi-Photonen-Polymerisation erforderlichen Bedingungen werden in der Regel nur in einer Zone erhöhter Intensität erreicht. Diese Zone erhöhter Intensität wird in einem Fokusbereich des Laser-Schreibstrahls bereitgestellt. Der Fokusbereich ist insofern eine Strahltaille des Laser-Schreibstrahls, welche durch geeignete Optiken (z.B. Strahlführungsoptik, Strahlformungsoptik und/oder ein Objektiv) erzeugt wird. Zur lithografischen Herstellung von ausgedehnten 3D-Strukturen kann dann der Fokusbereich nach Maßgabe von Geometriebeschreibungsdaten durch ein Volumen an Lithografiematerial bewegt werden und jeweils lokal einen Verfestigungsprozess auslösen.

Die Herstellung von dreidimensionalen Strukturen mittels Zwei-Photonen-Polymerisation erfolgt oft unter einem Arbeitsabstand von 100 µm bis 20 mm. Dabei ist der Arbeitsabstand ein Abstand zwischen dem Fokusbereich und einem optischen Abschlusselement eines Objektivs zur Erzeugung des Fokusbereichs. Bei derart geringen Arbeitsabständen kann ein Kontakt des Objektivs mit dem Lithografiematerial oftmals nicht verhindert werden. Häufig taucht das Objektiv in das Lithografiematerial ein. Ein Herstellungsverfahren, bei dem das Objektiv zumindest teilweise in das Lithografiematerial eintaucht, kann auch als Dip-In Multi-Photonen-Polymerisation bezeichnet werden. Daher gelangt das Lithografiematerial während der Herstellung von dreidimensionalen Strukturen häufig an das Objektiv und insbesondere an das optische Abschlusselement.

DE 101 11 422 A1 zeigt 3D-Laserlithografie unter Ausnutzung von Multi-Photonen-Polymerisation innerhalb eines Bades aus Lithografiematerial in einem Behälter. Die hierzu beschriebene Vorrichtung verfügt über eine Austrittsoptik zur Fokussierung des Laserstrahls auf einen Fokusbereich innerhalb des Behälters.

DE 10 2011 012 484 A1 offenbart 3D-Laserlithografie unter Ausnutzung von Multi-Photonen-Polymerisation innerhalb eines flüssigen Lithografiematerials, wobei eine Objektivlinse der Laseroptik in das Lithografiematerial eintaucht.

DE 10 2018 221 670 A1 beschreibt eine Vorrichtung zur optischen Bearbeitung eines Objekts. Die Vorrichtung umfasst ein Objektiv zur Belichtung des Objekts mittels eines Lichtstrahls, wobei zwischen dem Objektiv und dem Objekt eine Membran angeordnet ist, die von dem Objektiv beabstandet ist. Die Membran ist in Richtung einer optischen Achse des Lichtstrahls beweglich, wobei Positionierungselemente die Bewegung der Membran ermöglichen.

Der Erfindung liegt die Aufgabe zugrunde, eine Laserlithografie-Vorrichtung sowie ein Verfahren zum Erzeugen einer dreidimensionalen Struktur mittels der Laserlithografie-Vorrichtung bereitzustellen. Hierbei soll die Laserlithografie-Vorrichtung vorzugsweise kompatibel mit einer Vielzahl von unterschiedlichen Lithografiematerialien sein.

Gelöst wird diese Aufgabe durch eine Laserlithografie-Vorrichtung mit den Merkmalen des Anspruchs 1 und durch ein Verfahren zum Erzeugen einer dreidimensionalen Struktur mit den Merkmalen des Anspruchs 10. Vorteilhafte und bevorzugte Ausgestaltungen der Erfindung sind in den weiteren Ansprüchen enthalten.

Eine erfindungsgemäße Laserlithografie-Vorrichtung zum Erzeugen einer dreidimensionalen Struktur in einem Lithografiematerial umfasst eine Laserquelle zum Aussenden bzw. Ausstrahlen eines Laser-Schreibstrahls und ein Objektiv zum Fokussieren des Laser-Schreibstrahls in einem Fokusbereich (oft auch einfach als Fokus bezeichnet). Das Objektiv weist ein optisches Abschlusselement auf. Weiter umfasst die Laserlithografie-Vorrichtung eine Scan-Einrichtung zur Verlagerung des Fokusbereichs des Laser-Schreibstrahls relativ zu dem Lithografiematerial und eine Schutz-Einrichtung zum Verhindern eines Kontakts zwischen dem optischen Abschlusselement und dem Lithografiematerial. Die Schutz-Einrichtung ist an dem optischen Abschlusselement angeordnet.

Durch das Anordnen der Schutz-Einrichtung an dem optischen Abschlusselement kann ein direkter Kontakt zwischen optischen Abschlusselement und Lithografiematerial verhindert werden, insbesondere auch dann, wenn das Objektiv in das Lithografiematerial eintaucht. Dadurch können beispielsweise Probleme vermieden werden, wenn Lithografiematerialien zur Anwendung kommen, die Farbstoffe oder Komponenten enthalten, welche bei Kontakt mit dem optischen Abschlusselement dieses beschädigen. Weiter kann vorteilhafterweise ein Reinigungsaufwand des Objektivs nach dem Erzeugen der dreidimensionalen Struktur deutlich reduziert werden, insbesondere kann bei einem Tausch der Schutz-Einrichtung eine Reinigung des Objektivs ganz entfallen. Ebenfalls kann vorteilhafterweise eine Propagationsstrecke des Laser-Schreibstrahls innerhalb des Lithografiematerials durch die Wahl einer geeigneten Dicke der Schutz-Einrichtung reduziert werden, weshalb bei einer Verwendung von stark absorbierenden Lithografiematerialien sichergestellt ist, dass im Fokusbereich ausreichend Leistung des Laser-Schreibstrahls gelangt, um eine Polymerisation des Lithografiematerials zu induzieren. Daher ist die Laserlithografie-Vorrichtung aufgrund der Schutz-Einrichtung kompatibel mit einer Vielzahl von unterschiedlichen Lithografiematerialien.

Zusätzlich verhindert das Anordnen der Schutz-Einrichtung an dem optischen Abschlusselement, dass Verunreinigungen von dem optischen Abschlusselement in das Lithografiematerial eingebracht werden. Dadurch wird eine Kontamination des Lithografiematerials verhindert und das Erzeugen einer sterilen dreidimensionalen Struktur ermöglicht.

Weiter kann die Schutz-Einrichtung vorteilhafterweise als Puffer wirken, um Beschädigungen im Falle einer Kollision des Objektivs mit Proben innerhalb des Lithografiematerials oder einer bereits erzeugten dreidimensionalen Struktur zu reduzieren.

Der Laser-Schreibstrahl und das Lithografiematerial können derart aufeinander abgestimmt sein, dass das Lithografiematerial zur Erzeugung der dreidimensionalen Struktur mittels Multi-Photonen-Polymerisation lokal innerhalb des Fokusbereichs verfestigbar ist.

Der Laser-Schreibstrahl kann ein Dauerstrich-Laser-Schreibstrahl oder ein gepulster Laser-Schreibstrahl sein. Insbesondere kann ein Puls des gepulsten Laser-Schreibstrahls eine Pulsdauer von 50 Femtosekunden bis 500 Nanosekunden aufweisen.

Das Objektiv kann beispielsweise eine numerische Apparatur im Bereich von einschließlich 0,01 bis einschließlich 1,4 aufweisen.

Das optische Abschlusselement kann ein optisches Element aufweisen, durch welches der Laser-Schreibstrahl aus dem Objektiv austritt. Das optische Abschlusselement kann dasjenige optische Element umfassen oder bilden, welches das Objektiv begrenzt, insbesondere gegenüber einer Umgebung des Objektivs. Das optische Abschlusselement kann eine Abschlusslinse, insbesondere eine Sammellinse, oder ein Abschlussfenster, insbesondere eine Glasscheibe, umfassen oder bilden. Das optische Abschlusselement kann auch weitere Mittel, z.B. einen Klebstoff umfassen. Das optische Abschlusselement kann z.B. mittels des Klebstoffs in einem Objektivgehäuse des Objektivs befestigt sein.

Die Verlagerung des Fokusbereichs des Laser-Schreibstrahls relativ zu dem Lithografiematerial kann durch eine Ablenkung des Laser-Schreibstrahls und/oder durch eine Verlagerung des Lithografiematerials erfolgen. Die Scan-Einrichtung kann dazu ausgebildet sein, das Lithografiematerial oder eine geeignete Trägervorrichtung (z.B. Behälter, Substrat, o.ä.) für das Lithografiematerial zu verlagern. Hierzu kann die Scan-Einrichtung Aktuatoren, insbesondere Stellmotoren oder Linearmotoren, umfassen, die das Lithografiematerial verlagern. Zusätzlich oder alternativ kann die Scan-Einrichtung dazu ausgebildet sein, den Fokusbereich zu verlagern. Hierzu kann die Scan-Einrichtung eine Strahlführungs- und Lenkungsanordnung, beispielsweise in Form von Scannerspiegel und/oder akustooptische Deflektoren, aufweisen. Die Strahlführungs- und Lenkungsanordnung kann zwischen der Laserquelle und dem Objektiv bzw. dem optischen Abschlusselement angeordnet sein.

Die Strahlführungs- und Lenkungsanordnung kann ein Strahlformungsmodul zum Anpassen von Fokusgrößen und/oder zum dynamischen Abbilden komplexer Intensitätsmuster umfassen. Das Strahlformungsmodul kann zwischen der Laserquelle und dem Objektiv angeordnet sein.

Grundsätzlich kann die Schutz-Einrichtung einteilig ausgebildet sein. Die Schutz-Einrichtung kann insbesondere getrennt von dem Objektiv ausgebildet sein.

Die Schutz-Einrichtung kann dazu ausgebildet sein, den Kontakt zwischen dem optischen Abschlusselement und dem Lithografiematerial zu verhindern, wenn das Objektiv in das Lithografiematerial eingetaucht ist. Die Schutzeinrichtung kann dazu ausgebildet sein, teilweise und/oder vollständig in das Lithografiematerial eingetaucht zu werden.

Die Schutz-Einrichtung kann einen Brechungsindex aufweisen, der sich von einem Brechungsindex des Lithografiematerials unterscheidet. Der Brechungsindex kann aber vorzugsweise auch gleich sein. Die Schutz-Einrichtung kann einen Brechungsindex aufweisen, der sich von einem Brechungsindex des optischen Abschlusselements unterscheidet. Der Brechungsindex kann aber vorzugsweise auch gleich sein. Die Schutz-Einrichtung kann einen Brechungsindex aufweisen, der einen Wert hat, der zwischen einem Wert des Brechungsindex des optischen Abschlusselements und einem Wert des Brechungsindex des Lithografiematerials liegt.

Die Schutz-Einrichtung kann eine Dicke von 2 pm bis 4 mm, insbesondere 2 pm bis 500 pm, insbesondere 300 pm oder 60 pm, aufweisen.

Die Schutz-Einrichtung kann lösbar an dem optischen Abschlusselement angeordnet sein. Vorteilhafterweise kann dadurch die Schutz-Einrichtung ausgetauscht werden, wenn beispielsweise an der Schutz-Einrichtung Ablagerungen des Lithografiematerials vorhanden sind.

Die Schutz-Einrichtung kann derart an dem optischen Abschlusselement angeordnet sein, dass ein Hohlraum, beispielsweise eine Luftkammer, zwischen dem optischen Abschlusselement und der Schutz-Einrichtung vermieden wird. Die Schutz-Einrichtung kann unmittelbar an dem optischen Abschlusselement angeordnet sein, insbesondere dort dichtend anliegen. Insbesondere kann die Schutz-Einrichtung einen berührenden Kontakt mit dem optischen Abschlusselement aufweisen. Die Schutz-Einrichtung kann das optische Abschlusselement überdecken.

In einer Weiterbildung der Laserlithografie-Vorrichtung weist die Schutz-Einrichtung einen Film oder eine Folie auf. Vorteilhafterweise kann der Film oder die Folie relativ einfach an dem optischen Abschlusselement angeordnet werden und ist kostengünstig. Der Film oder die Folie kann an dem optischen Abschlusselement angeordnet sein. Der Film oder die Folie kann ein homogenes Flächengebilde aus sehr dünnem Kunststoff sein. Der Film oder die Folie kann eine Dicke von 2 pm bis 4 mm, insbesondere 2 pm bis 500 pm, insbesondere 300 pm oder 60 pm, aufweisen. Die Schutz-Einrichtung kann, insbesondere nur, ein Film oder eine Folie sein. Insbesondere kann die Schutz-Einrichtung vorzugsweise nur aus einem Film oder einer Folie bestehen.

In einer Weiterbildung der Laserlithografie-Vorrichtung ist die Schutz-Einrichtung dazu ausgebildet, an dem optischen Abschlusselement befestigt zu werden. Die Schutz-Einrichtung kann dazu ausgebildet sein, mittels lockerer molekulare Bindungen, insbesondere Van-der-Waals-Bindungen, an dem optischen Abschlusselement befestigt zu werden. Die Schutz-Einrichtung kann eine Adhäsionsfolie sein, die dazu ausgebildet ist, mittels Adhäsion an dem optischen Abschlusselement befestigt zu werden. Zusätzlich oder alternativ kann die Schutz-Einrichtung einen Halter zum Befestigen der Schutz-Einrichtung an dem Objektiv umfassen. Insbesondere kann der Halter ein O-Ring sein.

In einer Weiterbildung der Laserlithografie-Vorrichtung weist die Schutz-Einrichtung eine Klebstoffschicht zum Befestigen der Schutz-Einrichtung an dem optischen Abschlusselement auf. Vorteilhafterweise kann die Schutz-Einrichtung besonders einfach und zuverlässig mittels der Klebstoffschicht an dem optischen Abschlusselement befestigt werden. Die Klebstoffschicht kann an dem optischen Abschlusselement angeordnet sein. Die Klebstoffschicht kann eine Dicke von 2 pm bis 100 pm, insbesondere 2 pm bis 50 pm, insbesondere 20 pm, aufweisen. Die Schutz-Einrichtung kann, insbesondere nur, ein Aufkleber, insbesondere ein Klebeband, sein. Der Aufkleber kann die Klebstoffschicht und den Film oder die Folie umfassen. Insbesondere kann die Schutz-Einrichtung vorzugsweise nur aus einem Aufkleber bestehen. Je nach Ausgestaltung ist es denkbar, dass in einfacher Weise übliche Klebebänder oder Klebefolien zum Einsatz kommen.

In einer Weiterbildung der Laserlithografie-Vorrichtung beträgt ein Transmissionsgrad der Schutz-Einrichtung für den Laser-Schreibstrahl mindestens 80%, insbesondere 85%, 90%, 92%, 95% oder 98%. Vorteilhafterweise wird mit einem hohen Transmissionsgrad sichergestellt, dass im Fokusbereich ausreichend Leistung des Laser-Schreibstrahls gelangt, um eine Polymerisation des Lithografiematerials zu induzieren.

In einer Weiterbildung der Laserlithografie-Vorrichtung weist das Objektiv ein Objektivgehäuse auf. Das optische Abschlusselement ist von dem Objektivgehäuse aufgenommen, insbesondere gehalten. Das Objektivgehäuse weist oftmals wenigstens ein Element auf, das ungeeignet für einen Kontakt mit dem Lithografiematerial ist. Die Schutz-Einrichtung überdeckt dann vorzugsweise auch das genannte Element, um eine Kontakts zwischen dem Element und dem Lithografiematerial zu verhindern. Vorteilhafterweise kann dadurch das Objektiv besonders tief in das Lithografiematerial eintauchen.

Das Element kann als ungeeignet für den Kontakt mit dem Lithografiematerial bezeichnet werden, wenn beispielsweise im Falle des Kontakts das Element beschädigt wird oder ein hoher Reinigungsaufwand erforderlich ist, um das Lithografiematerial von dem Element zu entfernen. Unter einem hohen Reinigungsaufwand kann verstanden werden, dass eine Reinigung mittels Wischen mit einem sauberen Tuch nicht ausreichend ist, um das Lithografiematerial von dem Element zu entfernen.

Das Element kann eine Vertiefung des Objektivgehäuses umfassen, beispielsweise in Form einer Nut oder eines Gewindes. Insbesondere kann das Objektivgehäuse zwei Gehäuseteile umfassen, wobei das Objektivgehäuse eine Vertiefung in Form einer Nut an einer Verbindungsstelle beider Gehäuseteile hat. Zusätzlich oder alternativ kann das Element ein Bedienelement zum Korrigieren von Abbildungsfehler umfassen. Das Bedienelement kann ein Korrekturring umfassen. Abbildungsfehler können chromatische Aberration und/oder sphärische Aberration sein.

In einer Weiterbildung der Laserlithografie-Vorrichtung weist die Schutz-Einrichtung einen Brechungsindex auf, der von dem Objektiv korrigierbar ist. Durch das Korrigieren des Brechungsindex der Schutz-Einrichtung können Abbildungsfehler reduziert werden. Beispielsweise kann das Objektiv für den Brechungsindex der Schutz-Einrichtung korrigiert sein und bei geeigneter Wahl der Dicke der Schutz-Einrichtung kann eine Propagationsstrecke des Laser-Schreibstrahls innerhalb des Lithografiematerials derart reduziert werden, dass das Lithografiematerial einen Brechungsindex aufweisen kann, der nicht durch das Objektiv korrigierbar ist. Damit können auch Lithografiematerialien zur Erzeugung der dreidimensionalen Struktur verwendet werden, deren Brechungsindex nicht durch das Objektiv korrigierbar ist.

In einer Weiterbildung der Laserlithografie-Vorrichtung weist die Schutz-Einrichtung eine erste Schicht mit einem ersten Brechungsindex und eine zweite Schicht mit einem zweiten Brechungsindex auf. Der erste Brechungsindex unterscheidet sich von dem zweiten Brechungsindex. Die erste Schicht kann die Klebstoffschicht sein. Vorteilhafterweise kann mittels der ersten Schicht und der zweiten Schicht der Brechungsindex der Schutz-Einrichtung angepasst werden. Insbesondere kann der Brechungsindex der Schutz-Einrichtung derart angepasst werden, dass dieser durch das Objektiv korrigierbar ist. Die erste Schicht kann an dem optischen Abschlusselement sein. Die erste Schicht kann zwischen dem optischen Abschlusselement und der zweiten Schicht angeordnet sein. Der Brechungsindex der Schutz-Einrichtung kann eine Kombination aus dem ersten Brechungsindex und dem zweiten Brechungsindex sein.

In einer Weiterbildung der Laserlithografie-Vorrichtung umfasst die Laserlithografie-Vorrichtung eine weitere Schutz-Einrichtung zum Verhindern eines Kontakts zwischen dem optischen Abschlusselement und dem Lithografiematerial. Die weitere Schutz-Einrichtung ist an der zuvor beschriebenen, ersten Schutz-Einrichtung angeordnet. Vorteilhafterweise kann mittels der Schutz-Einrichtung und der weiteren Schutz-Einrichtung eine Propagationsstrecke des Laser-Schreibstrahls innerhalb des Lithografiematerials reduziert werden.

Die weitere Schutz-Einrichtung kann die Schutz-Einrichtung überdecken. Die weitere Schutz-Einrichtung kann gleich der Schutz-Einrichtung sein. Alternativ kann sich die weitere Schutz-Einrichtung von der ersten Schutz-Einrichtung in der Dicke oder dem Brechungsindex unterscheiden. Beispielsweise kann die Dicke der (ersten) Schutz-Einrichtung 60 pm und die Dicke der weiteren Schutz-Einrichtung 100 pm betragen.

Ein erfindungsgemäßes Verfahren zum Erzeugen einer dreidimensionalen Struktur in einem Lithografiematerial erfolgt mittels einer zuvor beschriebenen Laserlithografie-Vorrichtung.

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind. Gleiche und funktional entsprechende Elemente sind mit identischen

Bezugszeichen versehen. Dabei zeigen:
- Fig. 1: eine schematische Darstellung einer Laserlithografie-Vorrichtung zum Erzeugen einer dreidimensionalen Struktur in einem Lithografiematerial,
- Fig. 2: eine skizzierte Darstellung eines Objektivs der Laserlithografie-Vorrichtung von Fig. 1 mit einer Schutz-Einrichtung, wobei das Objektiv in das Lithografiematerial eingetaucht ist,
- Fig. 3: eine skizzierte Darstellung des Objektivs von Fig. 2 mit einer weiteren Schutz-Einrichtung,
- Fig. 4: eine skizzierte Darstellung des Objektivs von Fig. 3 mit einer zusätzlichen Schutz-Einrichtung,
- Fig. 5: eine weitere skizzierte Darstellung des Objektivs von Fig. 2,
- Fig. 6: eine skizzierte Darstellung des Objektivs von Fig. 5 während des Entfernens der Schutz-Einrichtung,
- Fig. 7: eine skizzierte Darstellung einer Variante des Objektivs von Fig. 2, und
- Fig. 8: eine skizzierte Darstellung einer weiteren Variante des Objektivs von Fig. 2 und einer Variante der Schutz-Einrichtung von Fig. 1 bis 7.

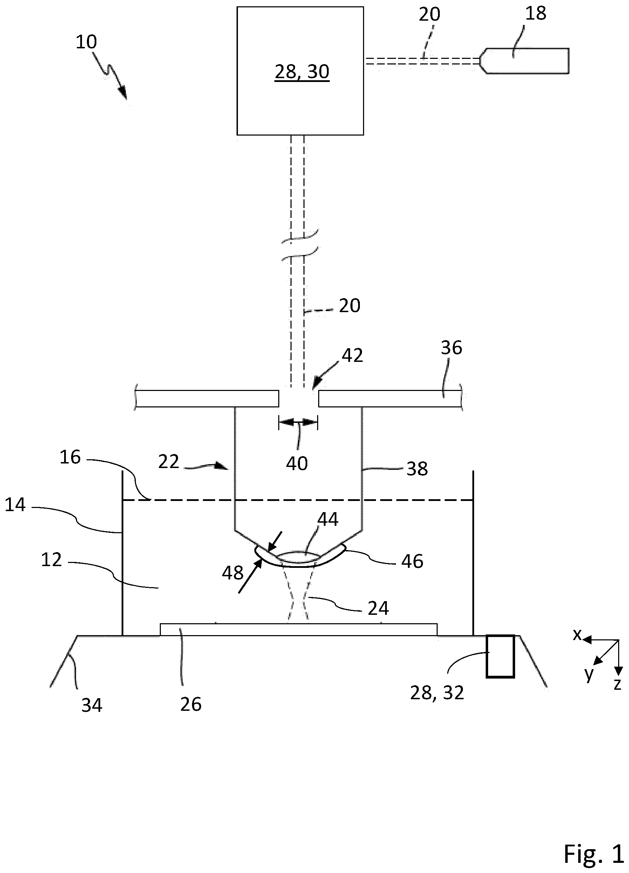

Fig. 1 zeigt eine schematische Darstellung einer Laserlithografie-Vorrichtung 10 zum Erzeugen einer dreidimensionalen Struktur in einem Lithografiematerial 12. Das Lithografiematerial 12 ist eine flüssige, fotosensitive Substanz, die von einem Behälter 14 aufgenommen ist und eine Lithografiematerialoberfläche 16 hat.

Die Laserlithografie-Vorrichtung 10 hat eine Laserquelle 18 zum Aussenden eines Laser-Schreibstrahls 20 und ein Objektiv 22 zur Fokussierung des Laser-Schreibstrahls 20 in einem Fokusbereich 24. Die dreidimensionale Struktur wird in diesem Fall durch lokale Verfestigung, insbesondere lokale Polymerisation, des Lithografiematerials 12 infolge von Multi-Photonen-Absorption innerhalb des Fokusbereichs 24 erzeugt. Die dreidimensionale Struktur soll im vorliegenden Beispiel auf einem Substrat 26 erzeugt werden, welches innerhalb des Behälters 14 angeordnet ist und von dem Lithografiematerial 12 umgeben ist. Je nach Anwendungsfall können aber auch Ausgestaltungen ohne Substrat und/oder ohne Behälter vorteilhaft sein.

Die Laserlithografie-Vorrichtung 10 hat eine Scan-Einrichtung 28 zur Verlagerung des Fokusbereichs 24 des Laser-Schreibstrahls 20 relativ zu dem Lithografiematerial 12. Hierzu verfügt die Scan-Einrichtung 28 über eine Strahlführungs- und Lenkungsanordnung 30 und über Aktuatoren 32 in Form von (hier beispielhaft drei) Stellmotoren.

Die Strahlführungs- und Lenkungsanordnung 30 ist innerhalb eines optischen Pfads des Laser-Schreibstrahls 20 angeordnet. Die Strahlführungs- und Lenkungsanordnung 30 lenkt den Laser-Schreibstrahl 20 aus. Die Strahlführungs- und Lenkungsanordnung 30 umfasst ein Strahlformungsmodul, das den Laser-Schreibstrahl 20 formt, beispielsweise anhand von Geometriebeschreibungsdaten der zu erzeugenden dreidimensionalen Struktur.

Die Aktuatoren 32 sind an einem Behälterhalter 34 der Laserlithografie-Vorrichtung 10 angeordnet zum Zweck der Verlagerung des Behälterhalters 34 in drei zueinander orthogonale Raumrichtungen x, y, z. Jeder der drei Stellmotoren der Aktuatoren 32 bewirkt eine Verlagerung in eine der Raumrichtungen x, y, z. Beispielsweise erfolgt eine Verlagerung des Behälterhalters 34 anhand von Geometriebeschreibungsdaten der zu erzeugenden dreidimensionalen Struktur.

Das Objektiv 22 ist an einer Kopfplatte 36 der Laserlithografie-Vorrichtung 10 montiert. Die Kopfplatte 36 kann mittels weiteren Aktuatoren der Scan-Einrichtung 28 verlagerbar sein.

Das Objektiv 22 hat ein Objektivgehäuse 38, das derart an der Kopfplatte 36 montiert ist, dass eine Eintrittsappertur 40 des Objektivs 22 mit einer entsprechenden Öffnung 42 der Kopfplatte 36 korrespondiert. Der Laser-Schreibstrahl 20 propagiert durch die Öffnung 42 und durch die Eintrittsapertur 40 entlang des optischen Pfads hindurch.

Das Objektiv 22 hat ein optisches Abschlusselement 44 in Form einer Abschlusslinse. Das optische Abschlusselement 44 ist von dem Objektivgehäuse 38 gehalten. Insofern bildet das Abschlusselement 44 den Übergang aus dem Objektiv 22 hinaus.

Die Laserlithografie-Vorrichtung 10 hat eine Schutz-Einrichtung 46 zum Verhindern eines Kontakts zwischen dem optischen Abschlusselement 44 und dem Lithografiematerial 12. Die Schutz-Einrichtung 46 ist unmittelbar an dem optischen Abschlusselement 44 angeordnet, so dass die Schutz-Einrichtung 46 einen berührenden Kontakt mit dem optischen Abschlusselement 44 aufweist. Die Schutz-Einrichtung 46 überdeckt das optische Abschlusselement 44 vollständig. Die Schutz-Einrichtung 46 überdeckt teilweise das Objektivgehäuse 38.

Durch das optische Abschlusselement 44 tritt der Laser-Schreibstrahl 20 aus dem Objektiv 22 heraus und propagiert durch die Schutz-Einrichtung 46 hindurch, um anschließend den Fokusbereich 24 zu bilden. Ein Transmissionsgrad der Schutz-Einrichtung 44 für den Laser-Schreibstrahl 20 beträgt vorzugsweise mindestens 90%.

Das Objektiv 22 ist zum Erzeugen der dreidimensionalen Struktur in das Lithografiematerial 12 eingetaucht. Mit anderen Worten, das optische Abschlusselement 44 befindet sich unterhalb der Lithografiematerialoberfläche 16. Die Schutz-Einrichtung 46 verhindert in einem eingetauchten Zustand des Objektivs 22 einen Kontakt zwischen dem optischen Abschlusselement 44 und dem Lithografiematerial 12. Daher ermöglicht die Schutz-Einrichtung 46 ein Eintauchen des Objektivs 22 in das Lithografiematerial 12, ohne dass dabei das optische Abschlusselement 44 durch das Lithografiematerial 12 beeinträchtigt (z.B. beschmutzt oder beschädigt) wird.

Im gezeigten Ausführungsbeispiel der Fig. 1 ist die Schutz-Einrichtung 46 ein Aufkleber in Form eines Klebebands. Die Schutz-Einrichtung 46 besteht dabei vorzugsweise nur aus dem Klebeband, das eine Klebstoffschicht und eine Folie umfasst. Die Klebstoffschicht ist eine erste Schicht mit einem ersten Brechungsindex. Die Folie ist eine zweite Schicht mit einem zweiten Brechungsindex. Der erste Brechungsindex kann sich von dem zweiten Brechungsindex unterscheiden, was jedoch nicht zwingend ist. Der effektive Brechungsindex der Schutz-Einrichtung 46 ist eine Kombination aus dem ersten Brechungsindex und dem zweiten Brechungsindex.

Die Folie wird mittels der Klebstoffschicht an das optische Abschlusselement 44 befestigt, insbesondere geklebt. Insgesamt hat die Schutz-Einrichtung 46 eine Dicke 48 von 60 µm.

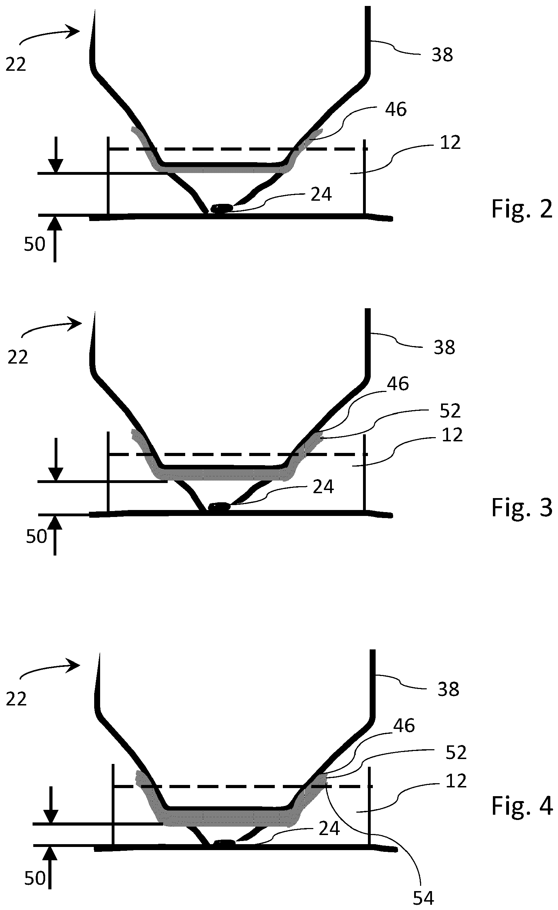

Fig. 2 zeigt eine skizzierte Darstellung des Objektivs 22, wobei das Objektiv 22 in das Lithografiematerial 12 eingetaucht ist. Beispielsweise ist das Lithografiematerial 12 für den Laser-Schreibstrahl 20 stark absorbierend. Der Laser-Schreibstrahl 20 propagiert innerhalb des Lithografiematerials 12 entlang einer Propagationstrecke 50, die sich von der Schutz-Einrichtung 46 bis zu dem Fokusbereich 24 erstreckt. Während der Propagation entlang der Propagationstrecke 50 wird der Laser-Schreibstrahl 20 von dem Lithografiematerial 12 absorbiert. Durch die Schutz-Einrichtung 46 mit der Dicke 48 von 60 pm hat sich die Propagationstrecke 50 innerhalb des Lithografiematerials 12 um 60 pm verringert. Durch die verringerte Propagationstrecke 50 gelangt mehr Leistung des Laser-Schreibstrahls 20 in den Fokusbereich 24.

Fig. 3 zeigt eine skizzierte Darstellung des Objektivs 22 von Fig. 2 mit einer weiteren Schutz-Einrichtung 52. Die weitere Schutz-Einrichtung 52 ist an der Schutz-Einrichtung 46 angeordnet. Die weitere Schutz-Einrichtung 52 überdeckt die Schutz-Einrichtung 46. Die weitere Schutz-Einrichtung 52 ist im Beispiel gleich der Schutz-Einrichtung 46 ausgebildet, weshalb hinsichtlich den Merkmalen der weiteren Schutz-Einrichtung 52 auf die Beschreibung zur Schutz-Einrichtung 46 verwiesen wird. Mittels der Schutz-Einrichtung 46 und der weiteren Schutz-Einrichtung 52 wird die Propagationsstrecke 50 des Laser-Schreibstrahls 20 innerhalb des Lithografiematerials 12 insgesamt um 120 pm reduziert. Durch die reduzierte Propagationstrecke 50 gelangt mehr Leistung des Laser-Schreibstrahls 20 in den Fokusbereich 24.

Fig. 4 zeigt eine skizzierte Darstellung des Objektivs 22 von Fig. 3 mit einer zusätzlichen (dritten) Schutz-Einrichtung 54. Die zusätzliche Schutz-Einrichtung 54 ist an der weiteren (zweiten) Schutz-Einrichtung 52 angeordnet. Die zusätzliche Schutz-Einrichtung 54 überdeckt die weitere Schutz-Einrichtung 52. Die zusätzliche Schutz-Einrichtung 54 ist beispielsweise gleich der (ersten) Schutz-Einrichtung 46 ausgebildet, weshalb hinsichtlich den Merkmalen der zusätzliche Schutz-Einrichtung 54 auf die Beschreibung zur Schutz-Einrichtung 46 verwiesen wird. Mittels der Schutz-Einrichtung 46, der weiteren Schutz-Einrichtung 52 und der zusätzlichen Schutz-Einrichtung 54 wird die Propagationsstrecke 50 des Laser-Schreibstrahls 20 innerhalb des Lithografiematerials 12 insgesamt um 180 pm reduziert. Durch die reduzierte Propagationstrecke 50 gelangt mehr Leistung des Laser-Schreibstrahls 20 in den Fokusbereich 24.

Durch das Anordnen mehrerer Schutz-Einrichtungen 46, 52, 54 wird die Propagationsstrecke 50 des Laser-Schreibstrahls 20 innerhalb des Lithografiematerials 12 derart reduziert, dass im Fokusbereich 24 ausreichend Leistung des Laser-Schreibstrahls 20 gelangt, um eine Polymerisation des Lithografiematerials 12 zu induzieren. Dadurch können Lithografiematerialien zum Erzeugen der dreidimensionalen Struktur verwendet werden, die den Laser-Schreibstrahl 20 stark absorbieren.

Der Brechungsindex der jeweiligen Schutz-Einrichtungen 46, 52, 54 unterscheidet sich beispielsweise von einem Brechungsindex des Lithografiematerials 12. Denkbar ist eine Ausgestaltung, bei der der Brechungsindex des Lithografiematerials 12 durch das Objektiv 22 nicht korrigiert werden kann, weshalb Abbildungsfehler in Form von chromatischer Aberration und/oder sphärischer Aberration auftreten, wenn der Laser-Schreibstrahl 20 innerhalb des Lithografiematerials 12 propagiert. Der Brechungsindex der jeweiligen Schutz-Einrichtungen 46, 52, 54 ist durch das Objektiv 22 korrigiert. Dadurch werden mittels des Anordnens von mehreren Schutz-Einrichtungen 46, 52, 54 zusätzlich die Abbildungsfehler verringert.

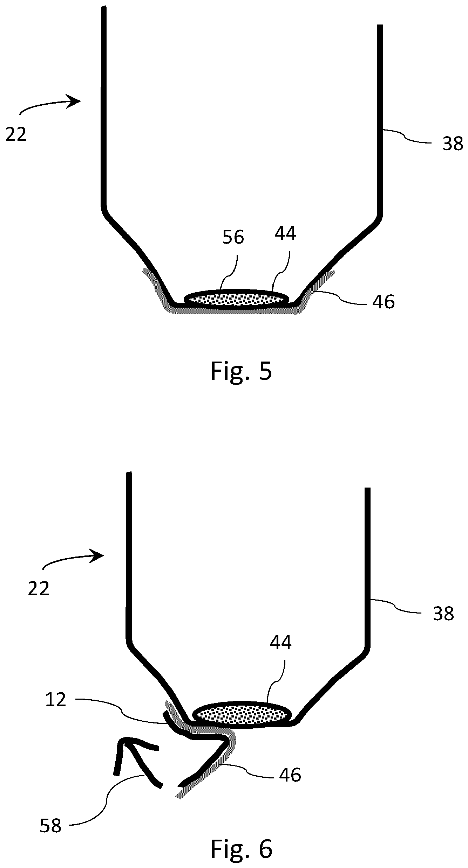

Fig. 5 zeigt eine weitere skizzierte Darstellung des Objektivs 22. An dem optischen Abschlusselement 44 haften Verunreinigungen 56 in Form von Bakterien und Viren. Die Schutz-Einrichtung 46 ist steril und ist derart an dem optischen Abschlusselement 44 angeordnet, dass die Verunreinigungen 56 nicht in das Lithografiematerial 12 eingebracht werden, auch wenn das Objektiv 22 in das Lithografiematerial 12 eintaucht. Dadurch wird eine Kontamination des Lithografiematerials 12 verhindert.

Fig. 6 zeigt eine skizzierte Darstellung des Objektivs 22 von Fig. 2 während des Entfernens der Schutz-Einrichtung 46. Das Objektiv 22 wurde zum Erzeugen einer dreidimensionalen Struktur genutzt und tauchte dabei in das Lithografiematerial 12 ein. Während der Herstellung hat sich an der Schutz-Einrichtung 46 Lithografiematerial 12 abgelagert. Um das Lithografiematerial 12 zu entfernen, wird lediglich die Schutz-Einrichtung 46 in Form des Klebebands von dem Objektiv 22 in eine Abziehrichtung 58 abgezogen. Die Klebstoffschicht ermöglicht ein rückstandsfreies Entfernen der Schutz-Einrichtung 46 von dem optischen Abschlusselement 44.

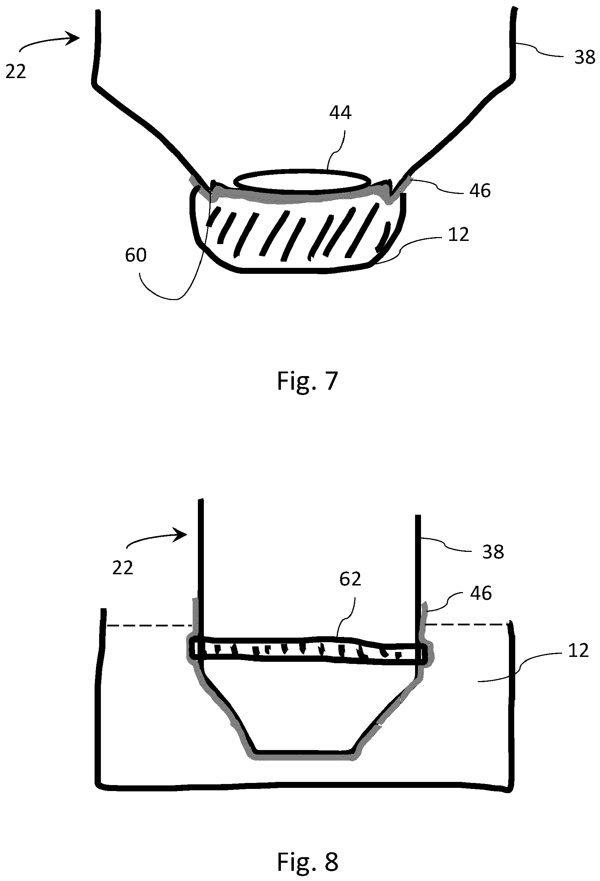

In Fig. 7 und 8 sind Varianten des Objektivs der Fig. 1 bis 6 und in Fig. 8 ist zusätzlich eine Variante der Schutz-Einrichtung der Fig. 1 bis 7 gezeigt, wobei für identische und funktionell äquivalente Elemente gleiche Bezugszeichen verwendet sind und insoweit auf die obigen Ausführungen zum Ausführungsbeispiel der Fig. 1 bis 6 oder zum Ausführungsbeispiel der Fig. 1 bis 7 verwiesen werden kann, so dass im Wesentlichen nur auf die bestehenden Unterschiede eingegangen wird.

Fig. 7 zeigt eine skizzierte Darstellung einer Variante 22 des Objektivs von Fig. 2. Das optische Abschlusselement 44 ist im Vergleich zur Variante der Fig. 1 bis 6 tiefer innerhalb des Objektivgehäuses 38 gehalten. Das Objektivgehäuse 38 hat einen Vorsprung 60. Die Schutz-Einrichtung 46 ist derart formbar, dass die Schutz-Einrichtung 46 an dem optischen Abschlusselement 44 ohne einen Hohlraum, beispielsweise eine Luftkammer, zwischen dem optischen Abschlusselement 44 und der Schutz-Einrichtung 46 angeordnet ist. Insbesondere ist die Schutz-Einrichtung 46 derart formbar, dass die Schutz-Einrichtung 46 ohne Bildung eines Hohlraums an dem Vorsprung 60 anliegt.

Fig. 8 zeigt eine skizzierte Darstellung einer weiteren Variante 22 des Objektivs von Fig. 2 und einer Variante 46 der Schutz-Einrichtung von Fig. 1 bis 7.

Die Schutz-Einrichtung 46 besteht nur aus einer Folie in Form einer Adhäsionsfolie. Die Adhäsionsfolie ist ein homogenes Flächengebilde aus sehr dünnem Kunststoff mit einer Dicke von 14 µm. Im Unterschied zum Ausführungsbeispiel der Fig. 1 bis 7 verfügt die Schutz-Einrichtung 46 der Fig. 8 nicht über eine Klebstoffschicht. Die Adhäsionsfolie wird mittels Adhäsion an dem optischen Abschlusselement 44 befestigt.

Das Objektivgehäuse 38 weist beispielsweise ein Element 62 auf, das ungeeignet für einen Kontakt mit dem Lithografiematerial ist. Das Element 62 ist im skizzierten Beispiel ein Bedienelement in Form eines umlaufenden Korrekturrings. Bei Betätigung des Elements 62 können Abbildungsfehler, beispielsweise chromatische Aberration und/oder sphärische Aberration, korrigiert werden.

Falls das Lithografiematerial 12 an das Element 62 gelangt, kann das Lithografiematerial 12 innerhalb des Objektivgehäuses 38 gelangen und das Objektiv 22 beschädigen oder verunreinigen. Eine Reinigung oder Reparatur des Objektivs 22 wäre aufwendig.

Um einen Kontakt zwischen dem Lithografiematerial 12 und dem Element 62 zu verhindern, überdeckt die Schutz-Einrichtung 46 das Element 62 vollständig. Dadurch kann das Objektiv 22 besonders tief in das Lithografiematerial 12 eintauchen. Insbesondere kann Objektiv 22 derart tief in das Lithografiematerial 12 eintauchen, dass das Element 62 sich unterhalb der Lithografiematerialoberfläche 16 befindet.

In einem alternativen Ausführungsbeispiel kann die Schutz-Einrichtung 46 ein Klebeband sein, welches das Element 62 vollständig überdeckt.

## Patentansprüche

1. Laserlithografie-Vorrichtung (10) zum Erzeugen einer dreidimensionalen Struktur in einem Lithografiematerial (12), umfassend
- eine Laserquelle (18) zur Aussendung eines Laser-Schreibstrahls (20),
- ein Objektiv (22) zur Fokussierung des Laser-Schreibstrahls (20) in einem Fokusbereich (24), wobei das Objektiv (22) ein optisches Abschlusselement (44) aufweist,
- eine Scan-Einrichtung (28, 30, 32) zur Verlagerung des Fokusbereichs (24) des Laser-Schreibstrahls (20) relativ zu dem Lithografiematerial (12), und
- eine Schutz-Einrichtung (46) zum Verhindern eines Kontakts zwischen dem optischen Abschlusselement (44) und dem Lithografiematerial (12),
- wobei die Schutz-Einrichtung (46) unmittelbar an dem optischen Abschlusselement (44) angeordnet ist,
**gekennzeichnet dadurch, dass**
- die Schutz-Einrichtung (46) eine Klebstoffschicht zum Befestigen der Schutz-Einrichtung (46) an dem optischen Abschlusselement (44) aufweist.

2. Laserlithografie-Vorrichtung (10) nach Anspruch 1,
- wobei die Schutz-Einrichtung (46) einen Film oder eine Folie aufweist.

3. Laserlithografie-Vorrichtung (10) nach einem der vorherigen Ansprüche,
- wobei die Schutz-Einrichtung (46) dazu ausgebildet ist, an dem optischen Abschlusselement (44) befestigt zu werden.

4. Laserlithografie-Vorrichtung (10) nach einem der vorherigen Ansprüche,
- wobei ein Transmissionsgrad der Schutz-Einrichtung (46) für den Laser-Schreibstrahl (20) mindestens 80%, insbesondere 85%, 90%, 92% oder 95%, beträgt.

5. Laserlithografie-Vorrichtung (10) nach einem der vorherigen Ansprüche,
- wobei das Objektiv (22) ein Objektivgehäuse (38) aufweist,
- wobei das optische Abschlusselement (44) von dem Objektivgehäuse (38) aufgenommen ist,
- wobei das Objektivgehäuse (38) ein Element (62) aufweist, das ungeeignet für einen Kontakt mit dem Lithografiematerial (12) ist,
- wobei die Schutz-Einrichtung (46) das Element (62) zum Verhindern eines Kontakts zwischen dem Element (62) und dem Lithografiematerial (12) überdeckt.

6. Laserlithografie-Vorrichtung (10) nach einem der vorherigen Ansprüche,
- wobei die Schutz-Einrichtung (46) einen Brechungsindex aufweist, der von dem Objektiv (22) korrigierbar ist.

7. Laserlithografie-Vorrichtung (10) nach einem der vorherigen Ansprüche,
- wobei die Schutz-Einrichtung (46) eine erste Schicht mit einem ersten Brechungsindex und eine zweite Schicht mit einem zweiten Brechungsindex aufweist,
- wobei der erste Brechungsindex sich von dem zweiten Brechungsindex unterscheidet.

8. Laserlithografie-Vorrichtung (10) nach einem der vorherigen Ansprüche, umfassend
- eine weitere Schutz-Einrichtung (52) zum Verhindern eines Kontakts zwischen dem optischen Abschlusselement (44) und dem Lithografiematerial (12),
- wobei die weitere Schutz-Einrichtung (52) an der Schutz-Einrichtung (46) angeordnet ist.

9. Verfahren zum Erzeugen einer dreidimensionalen Struktur in einem Lithografiematerial (12) mittels einer Laserlithografie-Vorrichtung (10) nach einem der vorherigen Ansprüche.
